Europäisches Patentamt

European Patent Office

Office européen des brevets

(11) Publication number: **0 166 307**
**B1**

## EUROPEAN PATENT SPECIFICATION

(45) Date of publication of patent specification: **28.02.90**

(21) Application number: **85107250.4**

(22) Date of filing: **14.06.85**

(51) Int. Cl.⁵: **G 03 F 7/36**

(54) **Process for forming a lift-off glass mask on a substrate.**

(30) Priority: **27.06.84 US 624878**

(43) Date of publication of application:
**02.01.86 Bulletin 86/01**

(45) Publication of the grant of the patent:
**28.02.90 Bulletin 90/09**

(84) Designated Contracting States:
**DE FR GB**

(56) References cited:
**EP-A-0 076 562**

**PATENT ABSTRACTS OF JAPAN, vol. 8, no. 181
(E-261)1618r, 21st August 1984; & JP-A-59 74
626
IBM TECHNICAL DISCLOSURE BULLETIN, vol.
26, no. 5, October 1983, page 2346, New York,
US; J. LAWSON et al.: "Fabrication of
micron/submicron metal lines"**

(73) Proprietor: **International Business Machines
Corporation
Old Orchard Road
Armonk, N.Y. 10504 (US)**

(72) Inventor: **Chaloux, Paul Normand, Jr.
609 Chelsea Cay
Wappingers Falls, N.Y. 12590 (US)**
Inventor: **Havas, Janos
Larchmont Drive
Hopewell Junction, N.Y. 12533 (US)**

(74) Representative: **Kreidler, Eva-Maria, Dr. rer. nat.
Schönaicher Strasse 220
D-7030 Böblingen (DE)**

Courier Press, Leamington Spa, England.

## Description

The invention relates to a process for forming a lift-off glass mask on a substrate where the underlay surface is modified to control the glass polymerization.

In the process of forming a glass lift-off mask on an underlay surface, the glass resin is often deposited over a photoresist made up of a solvent soluble polymer, specifically an organic layer. As the resin glass is spun onto the underlay surface, it has a tendency to polymerize. The polymerization occurs in a three-dimensional mode resulting in an unevenly distributed resin glass layer. If subsequent processing requires a step of etching the glass mask, the glass inclusions caused by the three-dimensional polymerization may not etch thoroughly and the glass which remains may present obstacles to subsequent processing, particularly if there is a need for a subsequently deposited layer to be planar and/or continuous. In the past, in order to eliminate the polymerization of glass resin, various extensive filtration techniques, such as filtering the glass through celite beds, have been utilized in efforts to "purify" the resin glass. Such attempts to prevent or modify the polymerization by treating the glass have proved unsuccessful; because, as herein disclosed, it has been determined that most of the polymerization takes place on the underlay surface itself, therefore requiring surface modification. Surface modification, in general, is not a new concept. Well-known teachings show surface modification to attain various ends, including increased adherence, better conductivity, improved dyeability and other ends (See: U.S. Patent 3,829,324 and discussions therein).

From Patent Abstracts of Japan, Vol. 8, No. 181 (E-261) (1618) August 21, 1984 a method for forming a pattern using a multilayer resist is known wherein a first organic matter layer is formed on a silicon substrate and heated for thirty min. at 200°C. Subsequently, the layer is surface-treated in a plasma atmosphere using oxygen. The resulting silicon compound layer on the first organic matter layer is thermally treated and a resist pattern is formed on said layer. The resist pattern is transferred into the silicon compound layer and from there into the first organic matter layer. By this method the stability of the pattern formed through the multilayer resist is improved.

It is an objective of the present invention to provide a process for forming a lift-off glass mask where the underlay surface is modified in order to control the polymerization of subsequently deposited resin glass.

The object of the invention is achieved by a process according to claim 1.

According to the invention an evenly distributed glass overlay surface is obtained and thus metal opens in glass lift-off/metallization processing are avoided. The method by which these objectives are attained teaches modification of the underlay surface onto which a resin glass layer is to be deposited. By modification of the underlying surface, to render it acidic rather than basic, the mode of the polymerization which takes place in the deposited glass is altered from a three-dimensional to a two-dimensional mode insuring even distribution of the resin glass layer.

FIG. 1 is a cross-sectional view of an unevenly distributed resin glass layer formed on an underlay surface in accordance with well-known techniques.

FIG. 2 illustrates the problem of residual glass deposits left after a glass etching step.

FIGS. 3A-3D are cross-sectional views of the ideal metallization/lift-off technique known in the art.

FIG. 3E is a perspective view of same.

FIGS. 4A-4D are cross-sectional views of the actual metallization/lift-off processes known in the art.

FIG. 4E is a perspective view of the same.

FIG. 5 is a cross-sectional view illustrating the inventive modification to the underlay surface.

FIG. 6 is a cross-sectional view of an evenly distributed resin glass layer deposited after applying the subject inventive method.

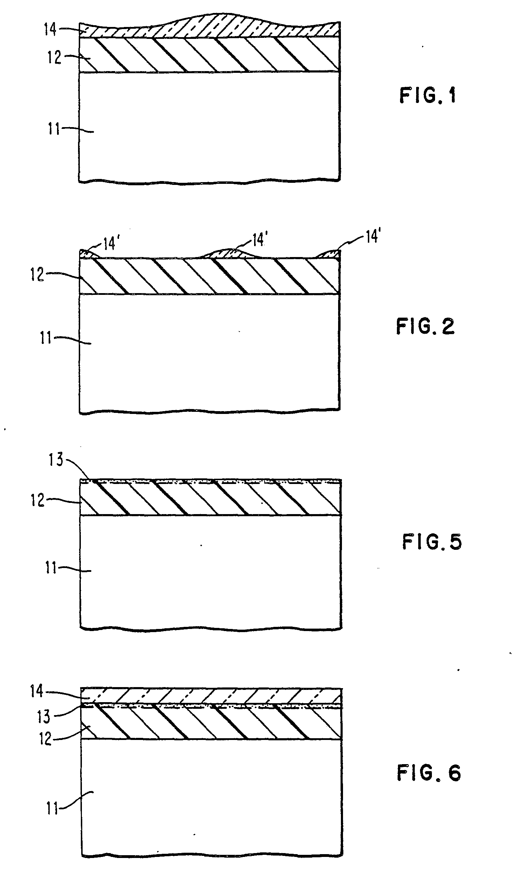

The difficulty addressed by the present invention is illustrated in FIGS. 1 and 2. When a resin glass layer, 14, is deposited onto an underlay surface, 12, it has a tendency to polymerize. If the underlay surface, 12, is made up of a compound which is a base, then the resin glass will polymerize in a three-dimensional mode, and as illustrated by layer 14 in FIG. 1, will result in localized thickness variations. Should a subsequent glass etching step be required using, for example, a reactive ion etch to uniformly remove the glass, the greater thicknesses of glass may not etch thoroughly. The resulting glass islands which remain, as illustrated in FIG. 2 at 14', can seriously affect subsequent processing and potentially destroy the utility of the resulting structure. Examples of the problems that the non-etched glass may present include the interruption of a subsequently deposited layer where continuity or planarity of the layer is essential or resistance of the glass to an etching step intended to selectively remove the underlying layer, 12, whereby the glass inclusion "protects" that layer from the desired etching.

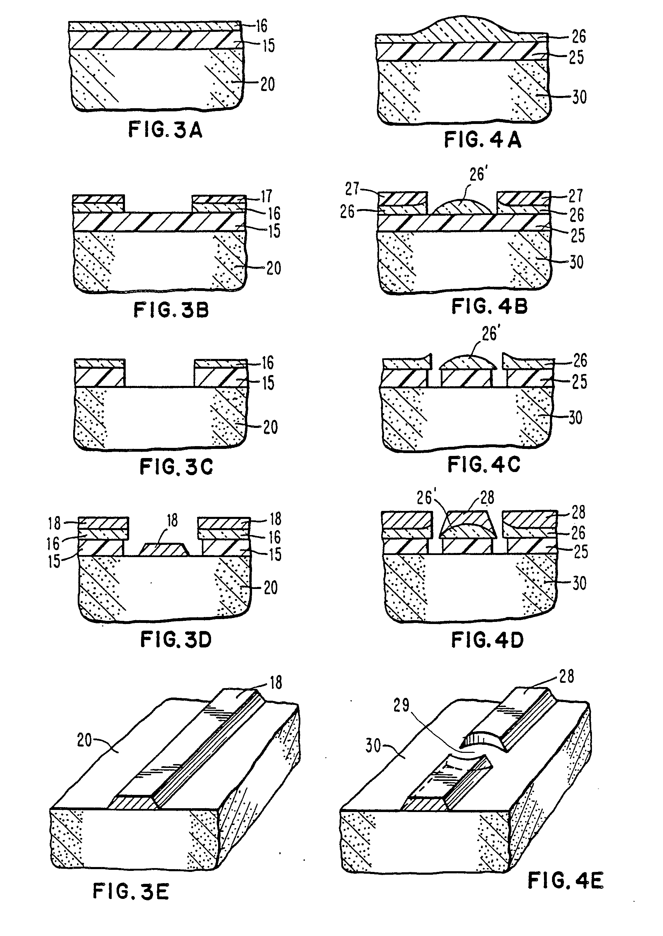

More specifically, the effect of the subject polymerization on the formation of metal patterned films utilizing transparent lift-off masks, as disclosed in U.S. Patents 4,004,044 and 4,202,914, is illustrated in FIGS. 3A-E and FIGS. 4A-E. FIGS. 3A-3D show the steps utilized in the above-cited patents to achieve the metal patterned film disclosed therein and illustrated in FIG. 3E. The steps involved are: A) depositing a photoresist layer 15, on a substrate, 20 and overlying said photoresist with a glass lift-off mask layer, 16; B) etching said lift-off mask, 16 by the use of an additional photoresist layer 17: C) removing the photoresist layers 17 and 15 in all exposed areas, leaving the exposed substrate in the non-mask areas; D) depositing metal layer 18; E) removing the remaining photoresist 15 and thereby removing the overlying metal and glass layers 18 and 16. The result is a metal channel, as illustrated in perspective at 3E, on the substrate surface. FIGS. 3A-E illustrate the ideal process and product embodiment as taught in patents 4,004,044 and 4,202,914. However, the glass polymerization problem discussed above can severely affect that process as illustrated in FIGS. 4A-4E.

A glass resin layer deposited on a photoresist layer will undergo polymerization in a three-dimensional mode; and, it will not occur as the perfectly planar surface that is seen at 16 on FIG. 3A. Rather, the glass layer will have localized thickness variations as FIG. 4A illustrates at 26. It is possible that the glass thickness variations would not affect the further processing; however, if the glass inclusions are located in the path of the subsequent etching and metallization steps, they prove fatal to the patterned film. As illustrated in FIG. 4B, a uniform etching step, for example, a reactive ion etch of the resin glass, will not remove all of the glass from the photoresist layer in the critical area. The glass island, 26', which remains acts as a shield for the underlying photoresist, 25, in the etching step of 4C. The metal layer, 28, deposited in the step illustrated at 4D is deposited over the glass island 26' rather than directly on substrate 30. Consequently, the metal is lifted off with the glass in the following process step when the remaining photoresist, 25, is removed; thereby leaving the substrate bare. Void, 29, in perspective view 4E illustrates the point at which the metallization has been interrupted by an open resulting from the glass inclusion.

Efforts to address this problem in the past, as noted above, concentrated on the resin glass, usually between 60% and 80% silicon dioxide, $SiO_2$, and 40% to 20% carbon, hydrogen and silicon molecules, using filtration techniques to "purify" and regulate the resin glass to be deposited. The proposed solution herein involves a modification of the underlay surface itself. As herein disclosed, it has been determined that polymerization of glass resin occurs at the underlay surface and that the mode of the polymerization can be affected and effected by modification of the nature of the surface itself. If the underlay surface is made up of a material which is basic, the resin glass undergoes a three-dimensional polymerization. If, however, an acidic surface is induced, the polymerization of the resin glass layer is in a two-dimensional, linear mode.

In the preferred embodiment herein, as illustrated in FIG. 5, the underlay surface, 12, is a photoresist layer, for example, a novolak/diazoquinone positive resist. The photoresist layer, 12, is comprised of an organic compound which is basic and which, upon direct resin glass deposition, by well-known spin on techniques, will induce a three-dimensional glass polymerization yielding the structure of FIG. 1. The inventive solution comprises modifying the photoresist underlay surface, 12, to render it acidic. This can be done by various alternative techniques, which would be obvious to one having ordinary skill in the art. However, in addition to rendering the surface acidic, the invention requires that there be no degradation of, nor change in the properties of the photoresist underlay. Therefore, in the preferred embodiment, the photoresist surface is exposed to a short plasma ash in order to oxidize it and thereby render it acidic. Since only the surface of the photoresist comes into contact with the subsequently deposited resin glass, it is only the surface or the first monolayer of the photoresist that need be oxidized. Plasma ashing is a method, well-known and fully described in the literature, which is generally used for removing a photoresist layer (see US-A-4,202,914, Col. 4, lines 38 et seq.). The plasma ashing step performed, therefore, must be of very short duration, for example 15-20 seconds, in order to induce the acidic surface *without* removing the photoresist. Furthermore, the plasma ash is chosen for the ability of the excited oxygen atoms to quickly attack the top monolayer of the surface of the organic resist layer, form hydroxyl or carboxvl groups, and have no deleterious effect on the properties of the photoresist layer. As illustrated in FIG. 5, the short ashing step provides the photoresist layer, 12, with an acidic surface monolayer, 13. When a resin glass layer is subsequently deposited over the acidic top surface monolayer, as illustrated in FIG. 6, the resin glass, 14, polymerizes linearly forming an evenly distributed layer free from the thickness variations attendant to the three-dimensional polymerization of the past.

## Claims

1. Process for forming a lift-off glass mask on a substrate wherein a solvent soluble polymeric layer (12) is deposited on a substrate (11) and the exposed surface of said layer (12) is treated in an oxidizing plasma
characterized in that
said plasma treatment step is a plasma a ashing step which is performed to form on said layer (12) an acidic surface monolayer (13)
and that subsequently a resin glass layer (14) is formed on said treated surface (13).

2. Process of claim 1 wherein solvent soluble polymer layer (12) comprises a novolak/diazoquinone positive resist.

3. Process of claim 1 wherein said oxidizing plasma comprises oxygen.

4. Process of claim 3 wherein said oxidizing plasma forms at least one radical selected from the group consisting of hydroxyl and carboxyl radicals.

5. Process of one or several of claims 1 to 4 further comprising the steps of:
forming a lift-off mask having a pattern of openings extending through layer (14) and coating (12) to substrate (11);
blanket depositing conductive metallurgy over said mask and in said openings; and

solvating remaining portions of layer (12) in a suitable solvent for removal thereof together with overlying portions of coating (14) and said metallurgy.

## Patentansprüche

1. Verfahren zum Herstellen einer Abhebeglasmaske auf einem Substrat, wobei eine lösungsmittellösliche Polymerschicht (12) auf einem Substrat (11) aufgebracht und die belichtete Oberfläche dieser Schicht (12) in einem oxidierenden Plasma behandelt wird,

dadurch gekennzeichnet, daß es sich bei dem Plasmabehandlungsschritt um einen Veraschungsschritt handelt, der zur Erzeugung einer säurehaltigen Oberflächenmonoschicht (13) auf besagter Schicht (12) durchgeführt wird, und

daß auf der behandelten Oberfläche (13) anschließend eine Harzglasschicht (14) ausgebildet wird.

2. Verfahren nach Anspruch 1, wobei die lösungsmittellösliche Polymerschicht (12) einen positiven Resist aus Novolak/Diazochinon enthält.

3. Verfahren nach Anspruch 1, wobei das oxidierende Plasma Sauerstoff enthält.

4. Verfahren nach Anspruch 3, wobei das oxidierende Plasma mindestens ein Radikal aus der Gruppe von Hydroxyl und Carboxyl enthält.

5. Verfahren nach einem oder mehreren der Ansprüche 1 bis 4, das außerdem folgende Schritte umfaßt:

Herstellen einer Abhebemaske mit einem Muster von Löchern, die sich durch die Schicht (14) und die Schicht (12) bis zum Substrat (11) erstrecken;

ganzflächiges Auftragen einer leitenden Metallschicht auf besagter Maske und in den Löchern sowie

Lösen der übrigen Teile der Schicht (12) in einem geeigneten Lösungsmittel, um dieselben zusammen mit den darüberliegenden Teilen der Schicht (14) und der Metallschicht zu entfernen.

## Revendications

1. Procédé de formation d'un masque d'enlèvement en verre sur un substrat, dans lequel on dépose une couche (12) de polymère soluble dans un solvant sur un substrat (11) et on traite la surface exposée de ladite couche (12) dans un plasma oxydant,

caractérisé en ce que

ledit traitement au plasma est une opération de calcination au plasma qui est effectuée de manière à former une monocouche de surface acide (13) sur ladite couche (12),

et en ce qu'on forme ensuite une couche de verre de résine (14) sur ladite surface traitée (13).

2. Procédé suivant la revendication 1, dans lequel la couche (12) de polymère soluble dans un solvant comprend une substance photosensible positive de type novolak/diazoquinone.

3. Procédé suivant la revendication 1, dans lequel ledit plasma oxydant comprend l'oxygène.

4. Procédé suivant la revendication 3, dans lequel ledit plasma oxydant forme au moins un radical choisi dans le groupe comprenant les radicaux hydroxyle et carboxyle.

5. Procédé suivant une ou plusieurs des revendications 1 à 4, comprenant en outre les opérations de:

formation d'un masque d'enlèvement comportant une configuration d'ouvertures qui traversent la couche (14) et le revêtement (12) jusqu'au substrat (11);

dépôt en couverture d'une métallurgie conductrice sur ledit masque et dans lesdites ouvertures; et

dissolution des parties restantes de la couche (12) dans un solvant approprié, pour leur élimination en même temps que les parties superposées du revêtement (14) et de ladite métallurgie.

14 —

12 —

11 —

**FIG. 1**

14' —

12 —

11 —

**FIG. 2**

13 —

12 —

11 —

**FIG. 5**

14 —
13 —
12 —

11 —

**FIG. 6**

FIG. 3A

FIG. 4 A

FIG. 3B

FIG. 4B

FIG. 3C

FIG. 4C

FIG. 3D

FIG. 4D

FIG. 3E

FIG. 4E